# EUROPEAN PATENT SPECIFICATION

(11) **EP 1 533 848 B1**
(45) Date of publication and mention of the grant of the patent: **04.06.2014**
(21) Application number: 04090447.6
(22) Date of filing: 18.11.2004
(51) Int. Cl.: H01L 27/32, H01L 27/02

(54) **Electroluminescence display**
Elktrolumineszente Anzeigevorrichtung
Dispositif d'affichage électroluminescent

(30) Priority: 19.11.2003 KR 2003082391
(43) Date of publication of application: 25.05.2005
(73) Proprietor: Samsung Display Co., Ltd., Yongin-City, Gyeonggi-Do, 446-711 (KR)
(72) Inventor: Chung, Bo-Yong, Samsung SDI Co., Ltd., Suwon-si, Gyeonggi-do (KR); Choi, Wong-Sik, c/o Samsung SDI Co., Ltd., Suwon-si, Gyeonggi-do (KR)
(74) Representative: Gulde & Partner

(56) References cited:
- US-A1- 2001 022 572
- US-A1- 2001 055 085
- PATENT ABSTRACTS OF JAPAN vol. 012, no. 127 (E-602), 20 April 1988 (1988-04-20) -& JP 62 252964 A (SEIKO EPSON CORP), 4 November 1987 (1987-11-04)
- PATENT ABSTRACTS OF JAPAN vol. 2002, no. 06, 4 June 2002 (2002-06-04) -& JP 2002 049330 A (SEIKO EPSON CORP), 15 February 2002 (2002-02-15)
- PATENT ABSTRACTS OF JAPAN vol. 2000, no. 21, 3 August 2001 (2001-08-03) -& JP 2001 100233 A (SHARP CORP), 13 April 2001 (2001-04-13)

## Description

### CROSS-REFERENCE TO RELATED APPLICATION

This application claims priority to and the benefit of Korean Patent Application No. 2003-82391, filed November 19, 2003, the disclosure of which is incorporated herein by reference in its entirety.

### BACKGROUND OF THE INVENTION

### 1. Field of the Invention

The present invention relates to an electro luminescence display and, more particularly, to an electro luminescence display in which an electromagnetic interference (EMI) shielding means capable of shielding the EMI by having a shielding means in a first power supply voltage line is contained to prevent noise or the like of the power supply voltage due to an internal or extrnal EMI from occurring.

### 2. Description of the Related Art

In recent years, various flat panel displays are developed which are capable of reducing weight and volume which are disadvantages of a cathode ray tube (CRT). Such a flat panel display includes a liquid crystal display, a field emission display, a plasma display panel, an electro luminescence display, and the like.

Among these displays, the electro luminescence display uses carriers such as electrons and holes to excite a fluorescent material to display image or video so that it may be driven by a low direct voltage and has a faster response speed. By these reasons, the electro luminescence display has been in the spotlight as the next,generation display and researches on new products have accelerated in recent years.

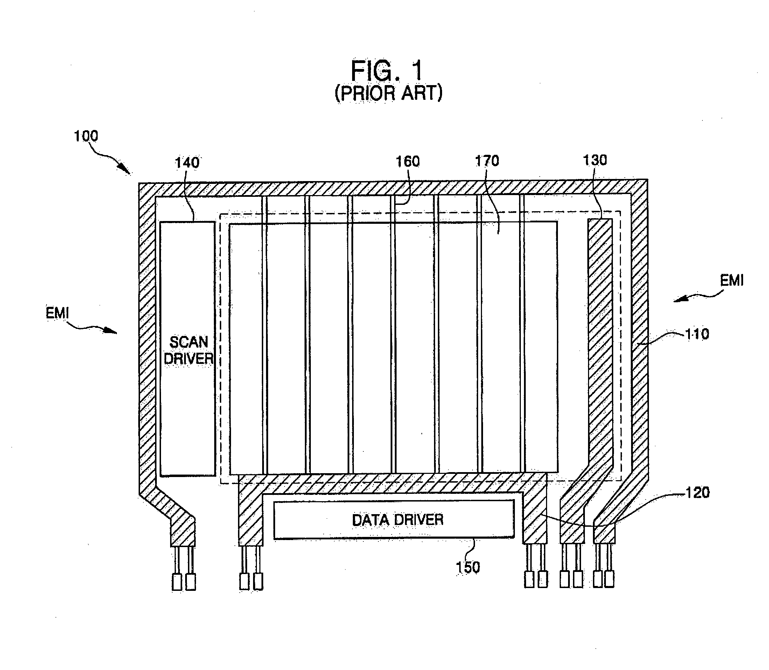

This electro luminescence display may be mainly classified into a passive matrix type and an active matrix type, and the active matrix electro luminescence display has an active switching device arranged in each pixel and has a voltage or current in response to the image data of the pixel applied to drive each emitting device. Such an active matrix type electro luminescence display is shown in FIG. 1.

FIG. 1 is a plan view of a conventional active matrix type electro luminescence display.

Numerical reference 100 indicates an electro luminescence display, 110 indicates a first upper power supply voltage line, 120 indicates a first lower power supply voltage line, 130 indicates a second power supply voltage line, 140 indicates a scan driver, 150 indicates a data driver, 160 indicates a first active power supply voltage line, and 170 indicates a pixel region.

As shown in the FIG. 1, the conventional electro luminescence display 100 includes the scan driver 140 applying a selection signal, the data driver 150 applying a data signal, the pixel region 170 emitting light in response to the selection signal and the data signal applied from the scan driver 140 and the data driver 150, the first upper and lower power supply voltage lines 110 and 120 delivering first power supply voltages, the second power supply line 130 delivering a second power supply voltage, and the first active power supply voltage line 160 applying, the power supply voltages delivered from the first power supply voltage lines 110 and 120 and the second power supply voltage delivered to the second power supply voltage line 130, to the pixel region 170.

When the selection signal and the data signal are applied from the scan driver 140 and the data driver 150 to the pixel region 170, switching transistors drive transistors (not shown) of the pixel region 170 are driven, and the first and second power supply voltages are applied to the pixel region 170 through the first power supply voltage lines 110 and 120 and the second power supply voltage line 130 so that each pixel of the pixel region 170 emits light. In this case, each of the first power supply voltages is opposite to that of the second power supply voltage.

However, the conventional electro luminescence display as described above has a problem that the waveform of the power supply voltage is distorted due to an internally or externally applied electromagnetic wave. That is, the power supply voltages delivered through the first upper and lower power supply voltage lines have noises which are resulted from the electromagnetic wave externally or internally delivered to thereby have non-uniformity in brightness.

In this regard, there are some inventions to improve the non-uniformity in brightness of the conventional electro luminescence display.

JP 62 252964 discloses a display element having a scan drivers and data drivers, the scan drivers and data drivers being connected with a plurality of pixels, the pixels comprising TFTs and picture elements, wherein the driving circuits (i.e. the scan drivers and the data drivers) are covered with interconnecting wires and connected to the periphery of a transparent insulating substrate in order to shield the scan drivers and the data drivers.

JP 2002/049330 discloses an active matrix type LC display in which a shielding electrode which is driven with a prescribed voltage is arranged between the picture signal line and the data line and JP 2001/100233 discloses a display device comprising an outer conductive pattern which is ground via an FPC 4 thereby reducing the influence by electric charges.

US 2001/022572 discloses a display device comprising a plurality of wirings, the wirings being connected to the source electrodes of the TFTs for electrically shielding the wirings from the wirings.

Further, US 2001/055085 discloses a display comprising an electric shielding wire made of Cr which is provided near the edge of the substrate.

However, the solutions provided by the above inventions could not sufficiently prevent the noise from the internally or externally applied electromagnetic wave.

### SUMMARY OF THE INVENTION

The present invention, therefore, solves aforementioned problems associated with conventional devices by providing an electro luminescence display having an EMI shielding means parallel to first power supply voltage lines wherein a specific voltage is applied to the EMI shielding means to pull the electromagnetic wave so that the electromagnetic wave otherwise affecting the power supply voltage may be shielded.

According to the present invention there is provided an electro luminescence display with the features of claim 1.

Further embodiments including the use of the above electro luminescence display of the present invention are subject matter of the dependent claims or could be learned from the following description.

### BRIEF DESCRIPTION OF THE DRAWINGS

The above and other features of the present invention will be described in reference to certain exemplary embodiments thereof with reference to the attached drawings in which:
FIG. 1 is a plan view of a conventional electro luminescence display of the conventional art;
FIG. 2 is a plan view of an electro luminescence display of the present invention. ; and
FIG. 3 is a plan view of a preferred embodiment of the present invention.

### DETAILED DESCRIPTION OF THE INVENTION

The present invention will now be described more fully hereinafter with reference to the accompanying drawings, in which preferred embodiments of the invention are shown.

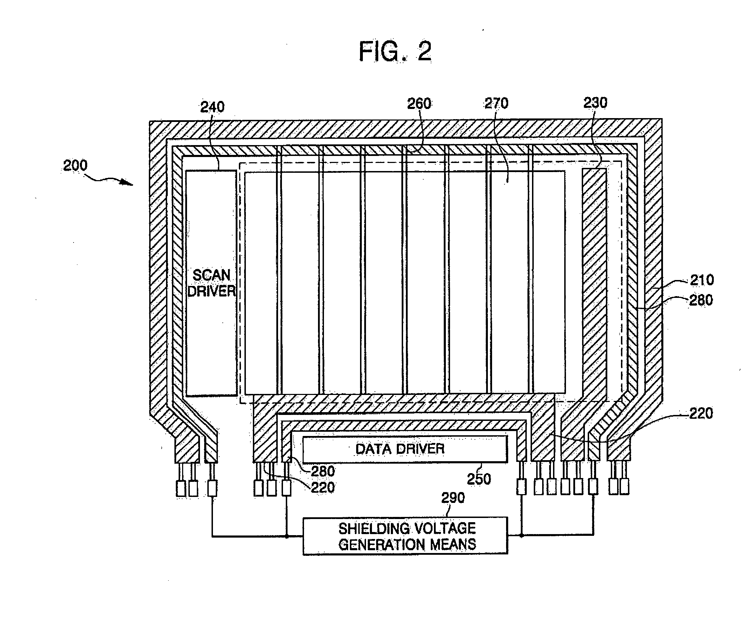

FIG. 2 is a plan view of an electro luminescence display of the present invention.

Numerical reference 200 indicates an electro luminescence display, 210 indicates a first upper power supply line, 220 indicates a first lower power supply voltage line, 230 indicates a second power supply voltage line, 240 indicates a scan driver, 250 indicates a data driver, 260 indicates a first active power supply voltage line, 270 indicates a pixel region, 280 indicates a metal line, and 290 indicates a shielding voltage generation means.

As shown in FIG. 2, the electro luminescence display 200 according to the present invention includes the scan driver 240, the data driver 250, the pixel region 270 emitting light in response to a selection signal and a data signal applied from the scan driver 240 and the data driver 250, the first upper and lower power supply voltage lines 210 and 220 delivering first power supply voltages, the first active power supply voltage line 260 applying the power supply voltages delivered from the first power supply voltage lines 210 and 220 to the pixel region 270, the second power supply voltage line 230 applying a second power supply voltage to the pixel region 270, the metal line 280 arranged parallel to the first power supply voltage lines 210 and 220 to shield an electromagnetic wave, and the shielding voltage generation means 290 for applying a shielding voltage to the metal line 280.

When the selection signal and the data signal are applied from the scan driver 240 and the data driver 250 to the pixel region 270, switching and drive transistors (not shown) of the pixel region 270 are turned on. As the drive transistor of the pixel region 270 is turned on, the power supply voltages applied to the first upper and lower power supply voltage lines 210 and 220 are applied to the pixel region 270 through the first active power supply voltage line 260, so that the pixel region 270 emits light.

In addition, the shielding voltage generation means 290 applies a specific voltage to the metal line 280 so that the specific current flows through the metal line 280 arranged parallel to each of the first upper and lower power supply voltage lines 210 and 220. In this case, the specific voltage applied to the metal line 280 preferably has a polarity opposite to that of each first power supply voltage.

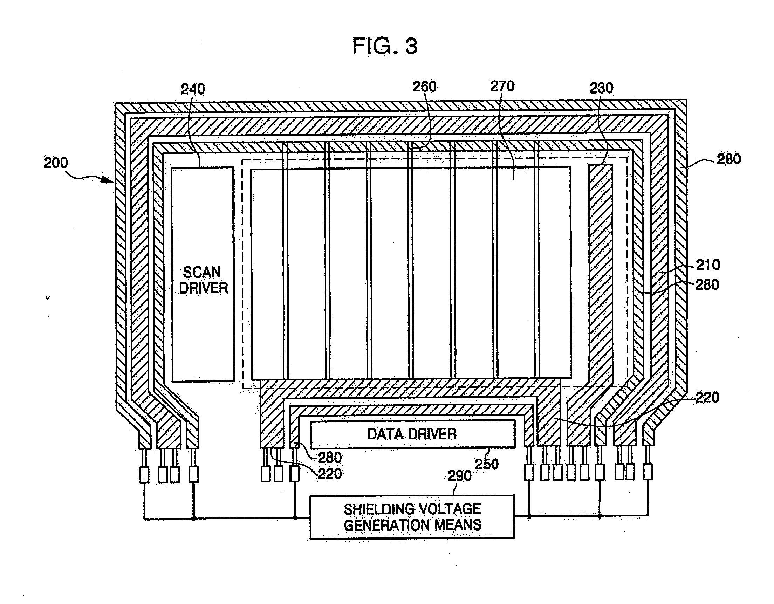

In addition, the metal line 280 and the first power supply voltage line 210 are spaced apart from each other by a constant interval to be parallel to each other as shown in FIGs. 2 and 3, however, the metal line 280 and the first power supply voltage line 210 may be isolated from each other by a separate insulating means interposed therebetween to achieve the purpose of the present invention in cases.

As a result, when the electromagnetic wave having magnetic field or electric field characteristics applied from an external source is applied to the first power supply voltage lines 210 and 220, the electromagnetic wave is shielded by the metal line 280 arranged parallel to the first power supply voltage lines 210 and 220. That is, the voltage applied to the metal line 280 has a polarity opposite to that of the first power supply voltage so that the electromagnetic wave is pulled by the metal line 280 by means of electrical characteristics which flow from positive to negative or from negative to positive. As a result, the power supply voltage is not affected by the electromagnetic wave.

FIG. 3 is a plan view of a preferred embodiment of the present invention.

The metal lines 280 are arranged inside and outside the first upper power supply voltage line 210 to shield the electromagnetic wave applied from an external source. That is, a specific voltage is applied to the metal lines 280 arranged inside and outside the first upper power supply voltage line 210 so that the electromagnetic wave applied from the external source may be shielded.

According to the present invention as mentioned above, the electromagnetic wave may be shielded by the metal line arranged parallel to the first power supply voltage lines so that noises of the power supply voltage do not occur, which allows non-uniformity in brightness due to the electromagnetic wave to be improved.

Although the present invention has been described with reference to certain exemplary embodiments thereof, it will be understood by those skilled in the art that a variety of modifications and variations may be made to the present invention without departing from the scope of the present invention defined in the appended claims.

## Claims

1. An electro luminescence display including a pixel region (270) in which devices adapted to emit light in response to a data signal are arranged in a stripe line structure or in a delta line structure, a scan driver (240) adapted to apply a switching signal to a gate electrode of a first switching device, a data driver (250) adapted to apply data information to a source electrode of the first switching device, and a power supply line (210) having a conductive characteristic for applying a first power supply voltage to the pixel region (270), the electro luminescence display comprising:
a first metal line (280) for shielding an electromagnetic wave having electric field or magnetic field characteristics, the first metal line (280) being arranged parallel to the power supply voltage line (210), and
a shielding voltage generating means (290) adapted for applying a shielding voltage to the first metal line (280) for shielding an electromagnetic wave having electric field or magnetic field characteristics,
**characterized in that**
the electro luminescence display further comprises a second metal line (280),
the first power supply line (210) is arranged between the first and second metal lines (280),
a shielding voltage generating means (290) further adapted for applying a shielding voltage to the second metal line (280) and connected to the first and second metal lines (280), and
the first and second metal lines (280) are arranged adjacent to the power supply line (210) over their whole lengths and the shape of the first and second metal lines (280) is concurrent to the shape of the power supply line (210).

2. The electro luminescence display as recited in claim 1, wherein the first metal line (280) is arranged between the pixel region (270) and the first power supply line (210).

3. Use of the electro luminescence display claimed in claim 1 or 2, wherein the shielding voltage generating means (290) is used for applying a shielding voltage which has a polarity opposite to that of the first power supply voltage.

## Patentansprüche

1. Elektrolumineszente Anzeigevorrichtung, beinhaltend einen Pixelbereich (270) in dem Vorrichtungen, die angepasst sind, in Reaktion auf ein Datensignal Licht zu emittieren, in einer Stripe-Linienstruktur oder in einer Delta-Linienstruktur angeordnet sind, einen Abtasttreiber (240), der angepasst ist, auf eine Gate-Elektrode einer ersten Schaltvorrichtung ein Schaltsignal anzuwenden, einen Datentreiber (250), der angepasst ist, auf eine Source-Elektrode der ersten Schaltvorrichtung Dateninformationen anzuwenden, und eine Spannungsversorgungsleitung (210), die eine leitende Eigenschaft zum Anlegen einer ersten Versorgungsspannung an den Pixelbereich (270) aufweist, wobei die elektrolumineszente Anzeigevorrichtung Folgendes umfasst:
eine erste Metallleitung (280) zum Abschirmen einer elektromagnetischen Welle, die Eigenschaften eines elektrischen oder magnetischen Felds aufweist, wobei die erste Metallleitung (280) parallel zur Spannungsversorgungsleitung (210) angeordnet ist, und
ein Abschirmungsspannungserzeugungsmittel (290), das angepasst ist, an die erste Metallleitung (280) eine Abschirmungsspannung zum Abschirmen einer elektromagnetischen Welle mit Eigenschaften eines elektrischen oder magnetischen Felds anzulegen,
**dadurch gekennzeichnet, dass**
die elektrolumineszente Anzeigevorrichtung ferner eine zweite Metallleitung (280) umfasst,
die erste Spannungsversorgungsleitung (210) zwischen der ersten und der zweiten Metallleitung (280) angeordnet ist,
das Abschirmungspannungserzeugungsmittel (290) ferner angepasst ist, an die zweite Metallleitung (280) eine Abschirmungsspannung anzulegen, und mit der ersten und zweiten Metallleitung (280) verbunden ist, und
die erste und die zweite Metallleitung (280) über ihre gesamte Länge benachbart zur Versorgungsleitung (210) angeordnet sind und die Form der ersten und der zweiten Metallleitung (280) mit der Form der Spannungsversorgungsleitung (210) übereinstimmt.

2. Elektrolumineszente Anzeigevorrichtung nach Anspruch 1, wobei die erste Metallleitung (280) zwischen dem Pixelbereich (270) und der ersten Spannungsversorgungsleitung (210) angeordnet ist.

3. Anwendung der elektrolumineszenten Anzeigevorrichtung nach Anspruch 1 oder 2, wobei das Abschirmungsspannungserzeugungsmittel (290) genutzt wird, eine Abschirmungsspannung anzulegen, die eine umgekehrte Polarität als die der ersten Versorgungsspannung aufweist.

## Revendications

1. Dispositif d'affichage électroluminescent comportant une zone de pixels (270) où des dispositifs adaptés pour émettre de la lumière en réponse à un signal de données sont agencés selon une structure linéaire en bande ou selon une structure linéaire en delta, un pilote de balayage (240) adapté pour appliquer un signal de commutation à une électrode de grille d'un premier dispositif de commutation, un pilote de données (250) adapté pour appliquer des informations de données à une électrode de source du premier dispositif de commutation, et une ligne d'alimentation électrique (210) ayant une caractéristique de conduction pour appliquer une première tension d'alimentation électrique à la zone de pixels (270), le dispositif d'affichage électroluminescent comprenant :
une première ligne métallique (280) permettant d'assurer une protection contre les ondes électromagnétiques ayant des caractéristiques de champ électrique ou de champ magnétique, la première ligne métallique (280) étant agencée de manière parallèle à la ligne de tension d'alimentation électrique (210), et
un moyen de génération de tension de blindage (290) adapté pour appliquer une tension de blindage à la première ligne métallique (280) pour assurer une protection contre les ondes électromagnétiques ayant des caractéristiques de champ électrique ou de champ magnétique,
**caractérisé en ce que**
le dispositif d'affichage électroluminescent comprend en outre une deuxième ligne métallique (280),
la première ligne d'alimentation électrique (210) est agencée entre les première et deuxième lignes métalliques (280),
un moyen de génération de tension de blindage (290) adapté en outre pour appliquer une tension de blindage à la deuxième ligne métallique (280) et relié aux première et deuxième lignes métalliques (280), et
les première et deuxième lignes métalliques (280) sont agencées de manière adjacente à la ligne d'alimentation électrique (210) sur toute leurs longueurs et la forme des première et deuxième lignes métalliques (280) est concourante à la forme de la ligne d'alimentation électrique (210).

2. Dispositif d'affichage électroluminescent selon la revendication 1, dans lequel la première ligne métallique (280) est agencée entre la zone de pixels (270) et la première ligne d'alimentation électrique (210).

3. Utilisation du dispositif d'affichage électroluminescent tel que revendiqué dans la revendication 1 ou 2, où le moyen de génération de tension de blindage (290) est utilisé pour appliquer une tension de blindage qui a une polarité opposée à celle de la première tension d'alimentation électrique.
